# EUROPÄISCHE PATENTSCHRIFT

(11) **EP 2 479 975 B1**
(45) Veröffentlichungstag und Bekanntmachung des Hinweises auf die Patenterteilung: **16.05.2018**
(21) Anmeldenummer: 12000289.4
(22) Anmeldetag: 19.01.2012
(51) Int. Cl.: H03H 7/32, H03J 5/24, H03K 3/037, H03L 7/099, H04N 3/22, H04N 3/27, H04N 3/16

(54) **Gesteuerte Grossignal-Kapazität und -Induktivität**
Controlled large signal capacity and inductivity
Capacité de grand signal commandée et inductivité

(30) Priorität: 22.01.2011 DE 102011009162
(43) Veröffentlichungstag der Anmeldung: 25.07.2012
(60) Teilanmeldung: 18000152.1
(73) Patentinhaber: Rehm, Markus, 78052 Villingen-Schwenningen (DE)
(72) Erfinder: Rehm, Markus, 78052 Villingen-Schwenningen (DE)

(56) Entgegenhaltungen:
- DE-A1- 19 546 928
- DE-A1- 19 723 307
- DE-A1- 19 925 742
- US-A1- 2004 218 406

## Beschreibung

### Technisches Gebiet der Erfindung

Die aktuelle Erfindung bezieht sich auf verstimmbare Induktivitäten oder Kapazitäten der Wechselstromelektronik, insbesondere auf geschaltete Induktivitäten oder Kapazitäten in Resonanzschaltungen.

### Hintergrund der Erfindung

Elektronisch verstellbare Induktivitäten bzw. Kapazitäten in Grosssignalanwendungen zu realisieren, ermöglicht es, abstimmbare Schwingkreise und Filter in vielen Anwendungsbereichen einzusetzen, wo es bis jetzt keine Alternativen gab. Bei solchen Anwendungen ist man an hohem Wirkungsgrad, stabilem zuverlässigen Betrieb und günstigem Preis interessiert. Der Entwurf von geschalteten Schaltungskonzepten, die all die genannten Anforderungen erfüllen sollen und die weit in den Hochfrequenzbereich funktionsfähig bleiben, ist eine echte Herausforderung. Zum einen sind die grundsätzlichen physikalischen Netzwerkbedingungen zu erfüllen. Zusätzlich gilt es Bauteileigenschaften zu berücksichtigen, welche die Netzwerkeigenschaften wesentlich mitbeeinflussen. Gesteuerte Reaktanzen basierend auf geschalteten Kapazitäten bzw. Induktivitäten weisen geringe Verluste auf und wurden in Bildröhren Horizontalablenkschaltungen eingesetzt.

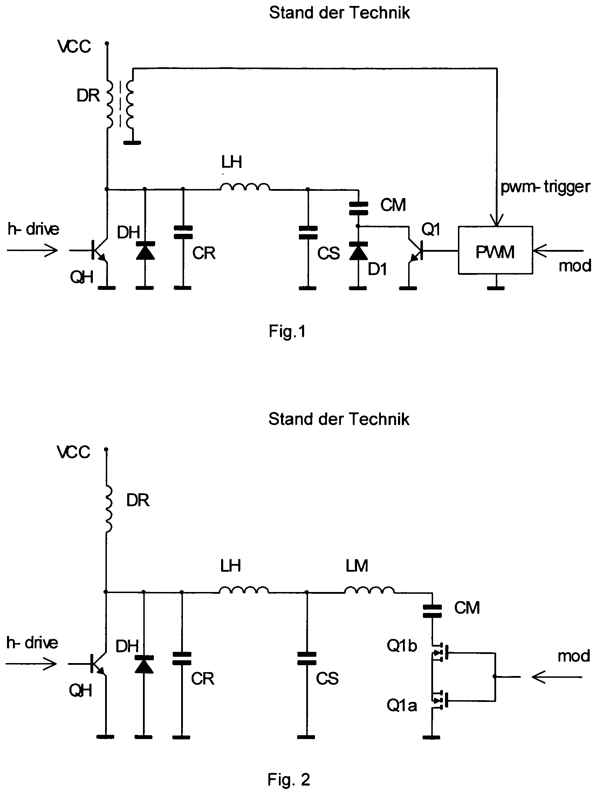

US4533855 zeigt, wie man die resultierende Gesamtkapazität zweier Kondensatoren mittels variablen Kopplungsintervalls während einer Teilperiode einer Schwingkreisperiode elektronisch steuert. Figur 1 zeigt die wesentliche Schaltung, darin bilden der Kondensator CS und die Induktivität LH einen Serienschwingkreis. Kondensator CM wird über den gesteuerten Schalter Transistor Q1 und die Diode D1 in einem Teilintervall der Schwingkreisperiode an CS gekoppelt. Die Kopplungssteuerung funktioniert nur in einer Halbperiode des Schwingkreises, da während der anderen Halbperiode D1 immer leitet. Der Kondensator CR ist nicht relevant da er über den Transistor QH und Diode DH kurzgeschlossen bleibt. Der Transformator DR entwickelt an seiner Sekundärwicklung einen Spannungspuls während dem Rückschlagintervall, welches nur von dem Ansteuersignal von QH abhängig ist. Daraus resultiert ein Pulsweitenmodulationssignal (nachfolgend als PWM Signal bezeichnet) am Steuereingang von Q1, das direkt mit dem Steuersignal an QH (h- drive) gekoppelt ist. Wird das PWM Signal über den Eingang (mod) verändert, verschiebt sich nur dessen Intervalllänge nicht aber dessen Phasenlage bezüglich h- drive.

US6586895 zeigt, wie man eine Induktivität oder ein Netzwerk höheren Grades mittels variablen Kopplungsintervalls während einer Teilperiode in beiden Halbwellen einer Schwingkreisperiode elektronisch steuert. Figur 2 zeigt die wesentliche Schaltung, darin bilden der Kondensator CS und die Induktivität LH einen Serienschwingkreis. Kondensator CM und die Induktivität LM werden über die gesteuerten Transistoren Q1a und Q1b und deren integrierten Dioden in zwei Teilintervallen der Schwingkreisperiode an CS gekoppelt. Die Kopplungssteuerung funktioniert in beiden Halbperioden des Schwingkreises, da der Strom in CM und LM in beiden Richtungen von der Ansteuerung der Transistoren Q1a respektive Q1b abhängig ist. Der Kondensator CR ist nicht relevant, da er über den Transistor QH und die Diode DH kurzgeschlossen bleibt; oder die Transistoren Q1a und Q1b ganz offen oder ganz geschlossen bleiben, wenn QH offen ist.

In den erwähnten Ansätzen wird ein PWM gesteuert, welches mit der Ablenkfrequenz synchronisiert wird. Dies wird mittels eines Sägezahngenerators ausgeführt, der direkt mit dem Eingangssignal h- drive oder über dem Zeilenrückschlagpuls synchronisiert wird. Bei all diesen Lösungen bleibt das PWM Signal unabhängig von der gesteuerten Kapazität bzw. Induktivität oder der daraus resultierenden Schwingkreisperiode. Der PWM Modulator ist somit nur von der Ablenkfrequenz (h- drive) und dem Eingang (mod) gesteuert.

Will man in einem LC- Schwingkreis mit gleichen Halbperioden die Frequenz über ein gesteuertes Kopplungsintervall von Kapazitäten bzw. Induktivitäten ändern, so muss das Kopplungsintervall in Phase zu der Schwingkreisperiode oder mindestens zu der entsprechenden Halbperiode generiert werden. Es kann nicht weiter ein vom Schwingkreis unabhängiges Signal zum Generieren der Schaltsignale der Transistoren herangezogen werden.

Das Erzeugen von Steuersignalen, welche unabhängig sind von der zu steuernden Grösse, ist sehr schwierig. Das Hauptproblem besteht darin, dass die ändernde Ausgangsgrösse sogleich die Eingangsgrösse ändert und somit das System instabil machen kann. Im diesem Fall hat die Frequenzänderung im Schwingkreis direkten Einfluss auf die Kopplungssteuerung. Durch Integration oder Tiefpassfilterung der Steuergrössen für den Sägezahngenerator kann man diesen Rückwirkungseinfluss minimieren und solche Systeme stabilisieren. Der grosse Nachteil dieser Variante ist ein schlechteres dynamisches Verhalten bezüglich des Steuereingangs. Das System wird träge und verlangsamt die Steuerung bezüglich des Steuereingangs. Die Kapazität bzw. Induktivität kann nur so schnell verändert werden, wie deren Ansteuersignale geändert werden können.

Für abstimmbare Schwingkreise oder Filter wünscht man sich eine Frequenzabstimmung, welche nur von einer Steuergrösse abhängig ist. Das heisst Amplitudenänderungen in Strom bzw. Spannung sollten die Frequenz nicht beeinflussen. Es gibt auch Anwendungen bei denen die Schwingkreisamplitude unabhängig zur Schwingkreisfrequenz gesteuert oder geregelt werden soll. Wird ein Schwingkreis gebildet, dessen Teilkomponenten mittels gesteuerter Teilintervallkopplung geändert werden können, ist es daher sehr wichtig, dass das PWM Signal unabhängig von Schwingkreisstrom- bzw. Schwingkreisspannungsamplitude gesteuert werden kann. Dies bedeutet, die resultierende Schwingkreisfrequenz wird eine Funktion einer Steuergrösse.

Kapazitäts- bzw. Induktivitätsänderung mittels Kopplungsteuerung in Schwingkreisen oder beliebigen Resonanzschaltungen erzeugen oft einen Stromfluss durch Dioden, welche meistens die integrierten Schalterdioden darstellen. Der Durchlassverlust der Dioden ist proportional zur Diodenschwellenspannung und dem Strom. Da es sich bei diesen Resonanzschaltungen oft um Zerovoltage Switching (ZVS) bzw. Zerocurrent Switching (ZCS) Konzepte handelt, sind die Verluste vorwiegend durch die Schalter- und deren Diodendurchlassverluste bestimmt. Weiter generieren transiente Vorgänge der Dioden im Übergang vom Sperr- in den Durchlassbetrieb und umgekehrt, Störsignale und daher zusätzliche Verluste. Es ist daher wichtig in effizienten Schaltungskonzepten, all diese Einflüsse wenn möglich zu vermeiden oder zumindest zu minimieren.

Ein elektrisches Resonanznetzwerk nach dem Oberbegriff des Anspruchs 1 ist aus der DE 19546928 A1 und der DE 19723307 A1 bekannt.

Die DE 19925742 A1 offenbart einen Oszillator mit einer veränderbaren Induktivität. Der Oszillator enthält einen LC-Schwingkreis mit mindestens einer Induktivität, und über eine mit der Oszillatorfrequenz betätigte Schaltvorrichtung ist eine weitere Induktivität periodisch parallel schaltbar. Ein Steuereingang der Schaltvorrichtung ist an eine veränderbare Gleichspannung angeschlossen. Entsprechend dem Verhältnis der Dauer des leitenden Zustandes und der Dauer des nichtleitenden Zustandes der Schaltvorrichtung ist innerhalb einer Schwingungsperiode des Oszillators die zeitgemittelte, wirksame Induktivität in Abhängigkeit von dem Wert der Steuerspannung veränderbar.

Die US 2004/218406 beschreibt ein berührungsloses elektrisches Energieübertragungssystem, das einen Transformator mit einer primären Wicklung enthält, die durch einen primären Resonanzkreis mit einer Stromquelle gekoppelt ist, und eine Sekundärwicklung, die mit einer Last über einen sekundären Schwingkreis gekoppelt ist. Die primären und sekundären Resonanzkreise sind induktiv miteinander gekoppelt. Eine primäre Steuerschaltung erfaßt Stromänderungen durch die primäre Resonanzschaltung, um eine Schaltfrequenz zu steuern, durch die ein im wesentlichen konstanter Energietransfer zwischen der Primärwicklung und der Sekundärwicklung aufrechterhalten wird.

Die nachfolgende Erfindung beschreibt ein Verfahren und dessen Detailimplementationen, um Kapazitäten bzw. Induktivitäten elektronisch zu steuern. Sie erfüllt alle erwähnten Anforderungen und zeichnet sich mit dem schnellstmöglichen Steuerverhalten aus. Eine Kapazität bzw. Induktivität lässt sich dadurch von einer Schwingkreishalbperiode zur nächsten in ihrem ganzen Aussteuerbereich variieren.

### Kurzbeschreibung der Zeichnungen

Figur 1 zeigt eine Schaltung zur Steuerung der Kapazität in einem Resonanznetzwerk nach einem ersten Stand der Technik.
Figur 2 zeigt eine Schaltung zur Steuerung der Induktivität in einem Resonanznetzwerk nach einem zweiten Stand der Technik.
Figur 3 zeigt das Blockdiagramm zur Steuerung einer Kapazität in einem Resonanznetzwerk gemäss der aktuellen Erfindung.
Figur 4 zeigt das Blockdiagramm einer Erweiterung zu Figur 3
Figur 5 zeigt Signale zu den Figuren 3 und 4.
Figur 6 zeigt das Blockdiagramm zur Steuerung einer Induktivität in einem Resonanznetzwerk gemäss der aktuellen Erfindung.
Figur 7 zeigt Signale zu Figur 6.
Figur 8 zeigt eine Detailschaltung zur Steuerung einer Kapazität in einem Resonanznetzwerk gemäss der aktuellen Erfindung.
Figur 9 zeigt ein Zustandsdiagramm der Schalter der Schaltung gemäss Figur 8.
Figur 10 zeigt eine Detailschaltung zur Steuerung einer Induktivität in einem Resonanznetzwerk gemäss der aktuellen Erfindung.
Figur 11 zeigt ein Zustandsdiagramm der Schalter der Schaltung gemäss Figur 10.

### Detaillierte Beschreibung der Erfindung

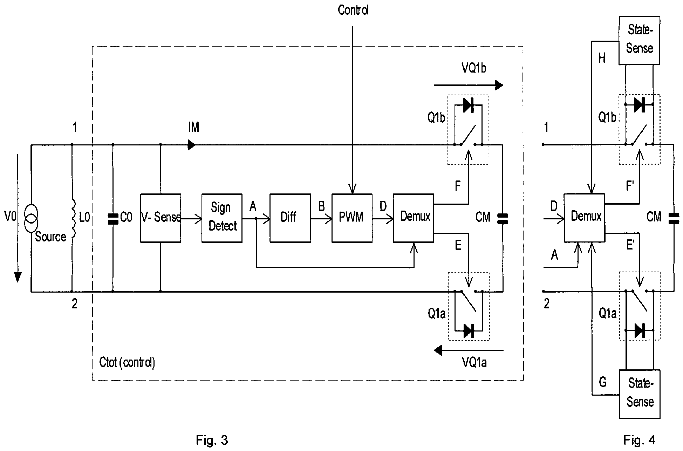

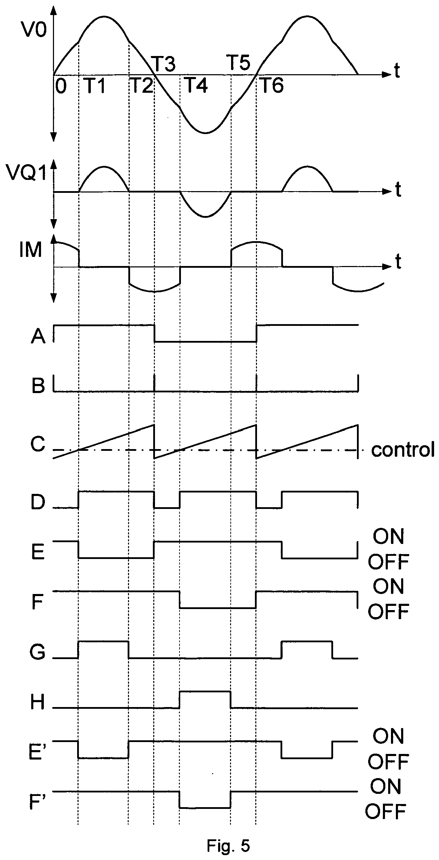

Figur 3 zeigt das Blockschaltbild eines Resonanznetzwerks, dessen Gesamtkapazität über eine elektrische Grösse variiert wird. Signalkurvenformen zu Figur 3 sind in Figur 5 gezeigt und sind in der weiteren Beschreibung mit dessen Indizes verwendet. Die Energiequelle (Source) ist über die Knoten 1 und 2 mit einem Parallelschwingkreis verbunden. Die Energiequelle kann dabei eine beliebige Wechselstromquelle oder ein beliebiger Teil eines angekoppelten LC-Speisungsnetzwerks sein (nicht gezeigt). Die Induktivität L0 und die Kapazität C0 bilden einen Schwingkreis. Der Kondensator CM wird über die Kopplungsschalter Q1a und Q1b an C0 gekoppelt. Die eingezeichneten Dioden deuten an, dass die Kopplungsschalter nur in eine Richtung steuerbar sind. In entgegengesetzter Stromrichtung bleiben Q1a und Q1b durch die Dioden überbrückt. In der weiteren Beschreibung definiert der Begriff Schalter funktionell den aktiv steuerbaren Teil von Q1a und Q1b. Der Begriff Kopplungschalter definiert funktionell den aktiv steuerbaren Teil und die Diode. Die erste Extremalbedingung der Schaltersteuerung stellt sich ein, wenn die Kopplungsschalter Q1a und Q1b immer offen sind. Dann ist die resultierende Gesamtkapazität gleich C0 und damit minimal. Dementsprechend ist die Schwingkreisfrequenz maximal. Die zweite Extremalbedingung der Schaltersteuerung stellt sich ein, wenn die Kopplungsschalter Q1a und Q1b immer geschlossen sind. Dann ist die resultierende Gesamtkapazität gleich der Parallelschaltung von C0 und CM und damit maximal. Dementsprechend ist die Schwingkreisfrequenz minimal. Für Teilintervallkopplung von CM mit C0 lässt sich jeder beliebige Zwischenwert der beiden Extremalwerte für die Gesamtkapazität über den Steuereingang Control einstellen. Dabei bedeutet Teilintervallkopplung dass C0 und CM während eines Teiles der resultierenden Schwingkreisperiode miteinander gekoppelt sind. Dies ist in der nachfolgenden Beschreibung als Zeit- oder Winkelinterval zu verstehen. Die gesamte Schaltung repräsentiert eine Gesamtkapazität (Ctot), deren Wert von Control gesteuert wird. Die Schwingkreisfrequenz ergibt sich als Mittelwert der ganzen Schwingkreisperiode. Die momentane Schwingkreisfrequenz wechselt innerhalb der Schwingkreisperiode zwischen minimaler und maximaler bzw. maximaler und minimaler Frequenz entsprechend den Zuständen der beiden Kopplungsschalter. Die resultierende Kondensatorspannung V0 wird im Block V- Sense abgegriffen und anschliessend dem Block Sign Detect zur Vorzeichenbestimmung zugeführt. Das Abgreifen der Kondensatorspannung kann auch nur eine Teilspannung umfassen, wichtig ist nur, dass das Vorzeichen des Ausgangssignals einen definierten Phasenbezug zur Spannung V0 über dem Kondensator C0 aufweist. Die daraus resultierende Kurvenform ist in A gezeigt. Der nachfolgende Differenzierer (Diff) leitet A nach der Zeit ab und gibt dessen Betrag aus, siehe Kurve B. Dies ergibt positive Pulse bei jedem Nulldurchgang 0, T3 und T6 der Schwingkreisspannung V0. Der Pulsweitenmodulator (PWM) generiert synchron zu den Pulsen von B einen Sägezahn C (in Figur 3 nicht gezeigt, da es sich um ein Signal innerhalb des PWM- Modulators handelt). Diese Sägezahnkurve C wird innerhalb des PWM Blocks mit der Steuergrösse Control verglichen. Ist Control kleiner als C, ist der PWM- Ausgang D hoch. Ist Control grösser als C, ist der PWM- Ausgang D tief. Basierend auf der bekannten Pulsweitenmodulation (PWM) ist der Modulator auf verschiedene Arten zu realisieren. Wesentlich ist nur, dass das PWM Signal D von B getriggert wird und von Control in seiner Pulslänge gesteuert wird. Der nachfolgende Block Demux wählt unter Benützung von Signal A einen Anteil der entsprechenden Halbwelle aus und führt ihn den Schaltern Q1a und Q1b zu. Ist A hoch, steuert das negierte Signal D über E den Schalter Q1a. Ist A tief, steuert das negierte Signal D über F den Schalter Q1b. Ist D über A mit dem entsprechenden Ausgang E bzw. F nicht verknüpft, bleibt E bzw. F hoch. Der Schalter Q1a bzw. Q1b ist geschlossen (ON) wenn E bzw. F hoch ist. Falls E bzw. F tief ist, sind Q1a bzw. Q1b offen.

Eine weitere funktionsfähige Möglichkeit die Schaltersignale zu generieren wäre, mit der positiven Flanke von D einen Frequenzteiler zu triggern und mit dessen Ausgang bzw. negiertem Ausgang direkt die Schalter Q1a bzw. Q1b anzusteuern (nicht gezeigt). Der Vorteil in der hier beschriebenen logischen Verknüpfung mit A liegt darin, dass die Schalter länger geschlossen bleiben. Es erweitert sich darum das Stromflussintervall in den Schaltern um das Intervall von T3 bis T4 in Schalter Q1a bzw. um das Intervall von 0 bis T1 in Schalter Q1b. So bleiben die Schalter immer mindestens für eine Halbperiode geschlossen und überbrücken ihre interne Diode. Dies resultiert in kleineren Durchlassverlusten und verhindert das Entstehen von Einschwingtransienten während dem Einschalten der Dioden. Die Dioden können immer noch einen gewissen Reststrom führen. Das Verfahren bewirkt auf jeden Fall eine Verringerung der Verluste vor allem, wenn der Durchlasswiderstand der Schalter (Rdson) genügend klein ist. Wird E tief, öffnet der Kopplungsschalter Q1a und es entwickelt sich eine positive sinusförmige Spannungshalbwelle in der Summenspannung von VQ1 = VQ1a + VQ1b während dem Zeitintervall von T1 bis T2. Während diesem Intervall fliesst kein Strom durch CM. Wird die Spannung VQ1 zu null (Zeitpunkt T2), erzwingt die gespeicherte Energie in L0 einen negativen Stromfluss in der internen Diode vom Kopplungsschalter Q1a. Dieser dauert von T2 bis T3 und wird durch den oben beschriebenen Prozess vom leitenden (bzw. invers leitenden) Schalter Q1a abgelöst. Die Kopplungsschalter Q1a und Q1b bleiben geschlossen bis das Signal F tief geht. Es entwickelt sich eine negative sinusförmige Spannungshalbwelle in der Summenspannung VQ1 während dem Zeitintervall von T4 bis T5. Während diesem Intervall fliesst kein Strom durch CM. Wird die Spannung VQ1 zu null (Zeitpunkt T5), erzwingt die gespeicherte Energie in L0 einen negativen Stromfluss in der internen Diode vom Kopplungschalter Q1b. Dieser dauert von T5 bis T6 und wird durch den oben beschriebenen Prozess vom leitenden (bzw. invers leitenden) Schalter Q1b abgelöst. Das gesamte Stromflussintervall der internen Dioden beschränkt sich auf das Intervall von T2 bis T3 und T5 bis T6.
Eine weitere Minimierung der Verluste lässt sich erreichen, wenn man den Schalter Q1a bzw. Q1b immer geschlossen hält, ausser während dem Intervall von T1 bis T2 bzw. von T4 bis T5. Dazu detektiert man in Figur 4 den Zustand der Kopplungsschalter im Block State- Sense. Dies kann mittels Strommesser (nicht gezeigt) oder wie in Figur 4 dargestellt über eine Schalterspannungsmessung realisiert werden. Der Ausgang G bzw. H wird danach weiter mit D und A im Demux Block verknüpft, um die Treibersignale E' und F' zu generieren. Dabei definiert D mit A den Übergang von hoch (ON) zu tief (OFF) siehe Zeitpunkt T1 in E' bzw. Zeitpunkt T4 in F'. Den Übergang von tief (OFF) zu hoch (ON) steuert G bzw. H mit der fallenden Flanke, siehe Zeitpunkt T2 in E' bzw. T5 in F'. Diese Variante ergibt den grössten Wirkungsgrad, da die Dioden in Ihrem gesamten Stromflussintervall überbrückt bleiben.

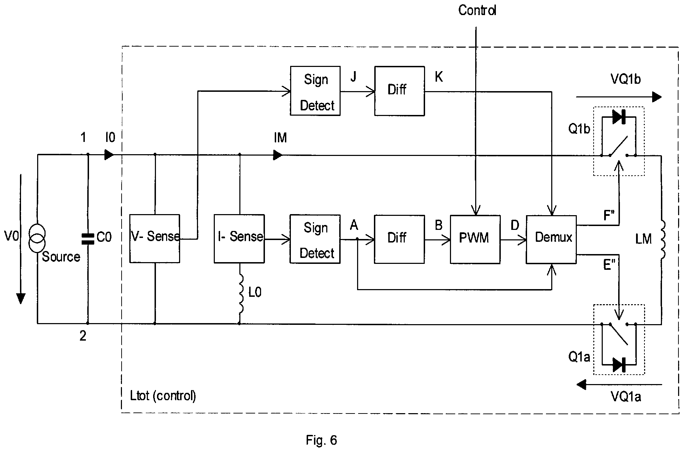

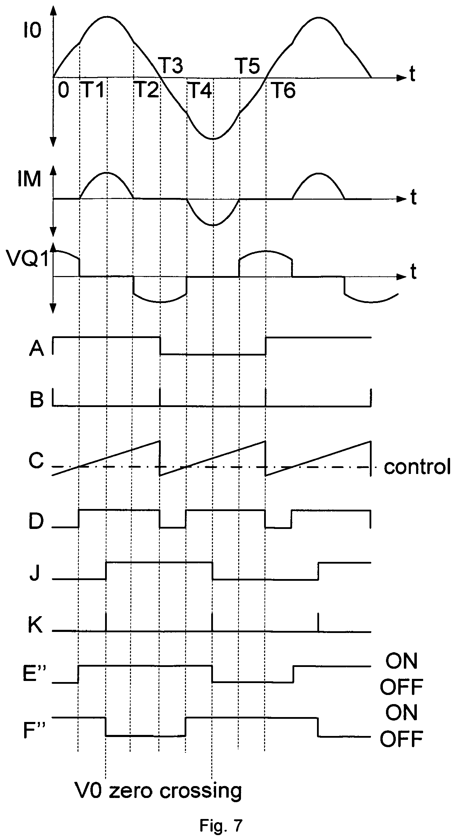

Figur 6 zeigt das Blockschaltbild eines Resonanznetzwerks, dessen Gesamtinduktivität über eine elektrische Grösse variiert wird. Signalkurvenformen zu Figur 6 sind in Figur 7 gezeigt und sind in der weiteren Beschreibung mit dessen Indizes verwendet. Die Energiequelle (Source) ist über die Knoten 1 und 2 mit einem Parallelschwingkreis verbunden. Die Energiequelle kann dabei eine beliebige Wechselstromquelle oder ein beliebiger Teil eines angekoppelten LC- Speisungsnetzwerks sein (nicht gezeigt).
Die Induktivität L0 und die Kapazität C0 bilden einen Schwingkreis. Die Induktivität LM wird über die Kopplungsschalter Q1a und Q1b an L0 gekoppelt. Die erste Extremalbedingung der Schaltersteuerung stellt sich ein, wenn beide Kopplungsschalter Q1a und Q1b immer offen sind. Dann ist die resultierende Gesamtinduktivität gleich L0 und damit maximal. Dementsprechend ist die Schwingkreisfrequenz minimal. Die zweite Extremalbedingung der Schaltersteuerung stellt sich ein, wenn beide Kopplungsschalter Q1a und Q1b immer geschlossen sind. Dann ist die resultierende Gesamtinduktivität gleich der Parallelschaltung von L0 und LM und damit minimal. Dementsprechend ist die Schwingkreisfrequenz maximal. Für Teilintervallkopplung von LM mit L0 lässt sich jeder beliebige Zwischenwert der beiden Extremalwerte für die Gesamtinduktivität über den Steuereingang Control einstellen. Die gesamte Schaltung repräsentiert eine Gesamtinduktivität (Ltot), deren Wert von Control gesteuert wird. Die Schwingkreisfrequenz ergibt sich als Mittelwert der ganzen Schwingkreisperiode. Die momentane Schwingkreisfrequenz wechselt innerhalb der Schwingkreisperiode zwischen minimaler und maximaler bzw. maximaler und minimaler Frequenz entsprechend den Zuständen der beiden Kopplungsschalter. Der resultierende Spulenstrom wird im Block I- Sense abgegriffen und anschliessend dem Block Sign Detect zur Vorzeichenbestimmung zugeführt. Das Abgreifen des Spulenstroms kann auch nur einen Teilstrom von I0 umfassen, wichtig ist nur, dass das Vorzeichen des Ausgangssignals einen definierten Phasenbezug zum Strom I0 in der Spule L0 aufweist. Die daraus resultierende Kurvenform ist in A gezeigt. Der nachfolgende Differenzierer (Diff) leitet A nach der Zeit ab und gibt dessen Betrag aus, siehe Kurve B. Dies ergibt positive Pulse bei jedem Nulldurchgang 0, T3 und T6 des Schwingkreisstromes I0. Der Pulsweitenmodulator (PWM) generiert synchron zu den Pulsen von B einen Sägezahn C (in Figur 6 nicht gezeigt, da es sich um ein Signal innerhalb des PWM- Modulators handelt). Diese Sägezahnkurve C wird innerhalb des PWM Blocks mit der Steuergrösse Control verglichen. Ist Control kleiner als C, ist der PWM- Ausgang D hoch. Ist Control grösser als C, ist der PWM- Ausgang D tief. Basierend der bekannten Pulsweitenmodulation (PWM) ist der Modulator auf verschiedene Arten zu realisieren. Wesentlich ist nur, dass das PWM Ausgangssignal D von B getriggert wird und von Control in seiner Pulslänge gesteuert wird. Der Block V- Sense greift die Spannung über L0 ab und der Block Sign Detect detektiert das Vorzeichen dieser Spannung siehe Signal J. Der nachfolgende Differentiator (Diff) leitet J nach der Zeit ab und gibt dessen Betrag aus, siehe Kurve K. Dies ergibt positive Pulse bei jedem Nulldurchgang der Schwingkreisspannung V0 (siehe V0 zerocrossing in Fig.7). Die Pulse von Signal K fallen zeitlich mit den Maxima bzw. Minima des Stromes I0 zusammen. Das Signal K wird mit A und D im Demux verknüpft, um die Treibersignale E" und F" der Schalter Q1a und Q1b zu generieren. Der Schalter Q1a bzw. Q1b ist geschlossen (ON), wenn E" bzw. F" hoch ist. Falls E" bzw. F" tief ist, ist Q1a bzw. Q1b offen. Ist A hoch, steuert das Signal D über E" das Schliessen von Schalter Q1a (siehe Zeitpunkt T1). Ist A tief, steuert das Signal D über F" das Schliessen von Schalter Q1b siehe (Zeitpunkt T4). Den Übergang von hoch (ON) zu tief (OFF) in E" und F" steuert Signal K mit A, siehe Zeitpunkte V0 zerocrossing in E" und F". Das Signal A selektiert dabei welcher Schalter gesteuert wird. Ist A tief, öffnet Schalter Q1a über E" mit K. Ist A hoch, öffnet Schalter Q1b über F" mit K. Die Steuerung der Schalterübergänge ON zu OFF mit Signal K halbiert das Diodenstromflussintervall gegenüber Steuersignalen, die nur mit A und D generiert werden (nicht dargestellt in Figur 7). Das kleinere Diodenstromflussintervall bewirkt kleinere Durchlassverluste und verhindert das entstehen von Einschwingtransienten während dem Einschalten der Dioden. Die Dioden können immer noch einen gewissen Reststrom führen. Das Verfahren bewirkt auf jeden Fall eine Verringerung der Verluste vor allem, wenn der Durchlasswiderstand der Schalter (Rdson) genügend klein ist. Wird E" hoch, schliesst der Kopplungsschalter Q1a und es entwickelt sich eine sinusförmige Stromhalbwelle in IM. Während diesem Intervall ist die gesamte Kopplungsschalterspannung VQ1 = VQ1a + VQ1b gleich null, da beide Kopplungsschalter geschlossen sind. Wird der Strom IM im Zeitpunkt T2 wieder null, erzwingt die gespeicherte Energie in C0 einen negativen Spannungssprung in der internen Diode von Q1b und folge dessen eine Unterbrechung des Stromflusses. Wird F" hoch, schliesst der Kopplungsschalter Q1b und es entwickelt sich eine negative sinusförmige Stromhalbwelle in IM während dem Zeitintervall von T4 bis T5. Während diesem Intervall ist die gesamte Kopplungsschalterspannung VQ1 gleich null, da beide Kopplungsschalter geschlossen sind. Wird der Strom IM im Zeitpunkt T5 wieder null, erzwingt die gespeicherte Energie in C0 einen negativen Spannungssprung in der internen Diode von Q1a und infolge dessen eine Unterbrechung des Stromflusses. Das Stromflussintervall der internen Dioden beschränkt sich auf das Intervall von V0 zerocrossing bis T2 der positiven Stromhalbwelle in IM bzw. T5 der negativen Stromhalbwelle in IM.

Gültig für alle Verfahren der Figuren 3, 4 und 6 ist die Unabhängigkeit der Schaltersignale E, E', E", F, F' und F" gegenüber Amplitudenänderungen von der Schwingkreisspannung und dem Schwingkreisstrom. Es ist leicht zu erkennen, dass die Schaltersignalerzeugung nur während einem kurzen Ereignis mit dem Schwingkreis gekoppelt ist. Dies entspricht einer Differenzierung eines Vorzeichenwechsels von Spannung bzw. Strom im Netzwerk. In dem beschriebenen Schaltungskonzept wird dies mit der Flankentriggerung ausgeführt. Dadurch haben Änderungen aller Schwingkreisgrössen, die zeitlich nicht mit dem Triggerereignis zusammenfallen, keinen Einfluss auf die Steuersignale der Schalter Q1a und Q1b. Somit ist die Kopplungsintervallsteuerung nur abhängig vom Steuereingang Control.
Es ist weiter leicht festzustellen, dass man die Steuergrösse (Control) von einer Schwingkreishalbperiode (von 0 bis T3) zur nächsten (von T3 bis T6 bzw. 0) ändern kann. So wird die kürzest mögliche Ansprechzeit bzw. die grösst mögliche Übertragungsbandreite bezüglich dem Steuereingang (Control) erreicht.
Die Steuerung der Kopplungschalter entspricht in den Figuren 3, 4 und 6 einem verzögertem Ein- oder Ausschalten. Die Verzögerung wird über eine Steuergrösse (Control) bestimmt.
Alle Funktionsblöcke der Figuren 3, 4 und 6 weisen Signalverzögerungen zwischen Eingangssignal und Ausgangssignal auf. Diese Signalverzögerungen begrenzen den frühestmöglichen Beginn des Abkopplungsintervalls (T1, T4 in den Figuren 5 und 7). Dies begrenzt den Aussteuerungsbereich weil in einem Aussteuerungsextremfall in den Figuren 3, 4 und 5 die Schalter Q1a und Q1b beim Nulldurchgang der Spannung V0 bereits wieder offen sein sollten. Gleichbedeutend begrenzt sich der Aussteuerungsbereich der Figuren 6 und 7 weil im einen Aussteuerungsextremfall die Schalter Q1a und Q1b beim Nulldurchgang des Stromes I0 bereits wieder geschlossen sein sollten. Um dies zu kompensieren, können einer oder mehrere Blöcke in den Figuren 3, 4 und 6 die Phasen in ihrer Übertragungsfunktion vordrehen. So lassen sich die Laufzeiten bzw. Verzögerungen ausgleichen, und der gesamte Aussteuerungsbereich lässt sich nutzen. Dies bedeutet z. Bsp., die Sägezahnkurve würde früher als in den Figuren 5 und 7 getriggert. Der Schnittpunkt mit dem Control Signal erscheint dann vor dem eigentlichen Nulldurchgang der Schwingkreisspannung oder des Schwingkreisstromes. Auf diese Weise lassen sich die Schalter in ihren Zustand versetzen, den sie bei Erreichen des genannten Nulldurchgangs für Vollaussteuerung benötigen. Für diesen Fall fallen T1 und 0 bzw. T4 und T3 zusammen. So ergibt sich ein fortlaufender Übergang der beiden Spannungshalbwellen (VQ1 in Figur 5) bzw. Stromhalbwellen (IM in Figur 7). Es lassen sich sogar V- Sense durch I- Sense Blöcke und umgekehrt ersetzen in den Figuren 3, 4 und 6 (nicht gezeigt). Zudem können einige der Signale A, G, H oder J negiert benützt werden.

So erhält man eine noch grössere Phasenvordrehung. Diese Möglichkeiten können sich aufzwingen, wenn man die hier beschriebenen Konzepte in Frequenzbereichen anwendet, wo die gesamte Signalverzögerung 90 Grad und mehr einer Netzwerkperiode beträgt. Weiter können durch die erforderliche Phasenvordrehung annähernd optimale Schaltsignale E' und F' (Figur 4) bzw. E" und F" (Figur 6) erhalten werden ohne die State- Sense Blöcke in Figur 4 bzw. ohne den zusätzlich V- Sense Block in Figur 6. Dazu wird in Demux die Logikverknüpfung je nach erforderlichen Ausgangssignalen angepasst. Es kann dazu z. Bsp. anstelle des Signals A das inverse Signal A in Demux verwendet werden (nicht dargestellt). Das Implementieren dieser Möglichkeiten ergibt sich je nach verwendeter Logik- und Schaltereigenschaften, gewünschter Netzwerkresonanzfrequenz und dem gewünschten Abstimmbereich.

Aus der Netzwerktheorie ist bekannt, dass sich Parallelschaltungen beliebig in Serienschaltungen umwandeln lassen und umgekehrt. Weiter lassen sich in deren Schaltungen die Komponenten beliebig permutieren. So ist klar, dass sich die beschriebenen Konzepte in den Figuren 3, 4 und 6 direkt auf eine Serienschaltung der Komponenten C0, Cm, L0 bzw. L0, LM, C0 anwenden lässt. Zudem kann die Koppelschaltung grundsätzlich aus einer oder zwei Kapazitäten (CM) oder Induktivitäten (LM) bestehen. Weiter ist klar, dass sich die vorgestellten Konzepte auch auf asymmetrische Netzwerkperioden bzw. auf nur einen Kopplungschalter anwenden lassen.

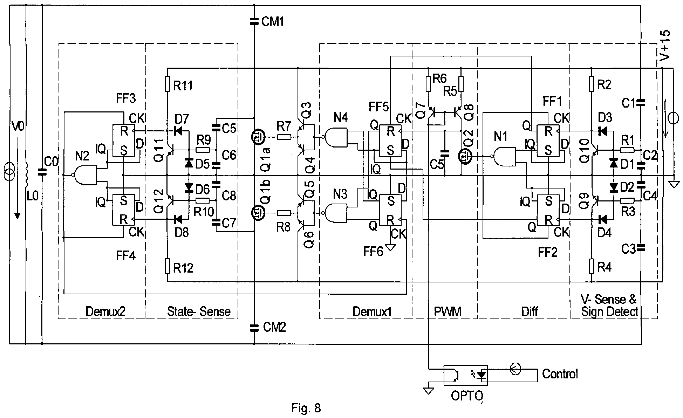

Figur 8 zeigt eine Detailschaltung nach Figur 4. Die gestrichelten Linien umfassen Teile des Blockschaltbildes. In der weiteren Beschreibung werden Kurvenformen der Figur 5 mit deren Indizes referenziert. CM ist als Serienschaltung von 2 Kondensatoren CM1 und CM2 ausgeführt, welche über Q1a und Q1b an C0 gekoppelt wird. Die Schalteransteuerung wird an einer Speisespannung V+15 betrieben. Ein Optokoppler überträgt die Steuerinformation (Control) galvanisch getrennt, da die Schaltersteuerung um V+15 vom Rest des Netzwerks galvanisch getrennt sein soll. Die Kondensatoren C1 und C2 greifen die positive Spannungshalbwelle von V0 ab und führen sie über R1 an die Basis von Transistor Q10. Q10 agiert als quasi Spannungs-Nullpunktdetektor der positiven Halbwelle. D1 und D3 beschleunigen das Abschalten sobald die Spannung über C2 unter die Schwellenspannung von Q10 fällt. Der kapazitive Spannungsteiler C1, C2 verhindert eine Gleichspannungskopplung mit V0. Zusätzlich lässt sich über R1, C1 und C2 eine Phasenvordrehung erreichen. Zu diesem Zweck sind diese Komponenten so dimensioniert, dass die Phasenvordrehung mindestens so groß ist wie die gesamte Signalverzögerung der Steuerschaltung. Dadurch lässt sich der komplette Aussteuerbereich nutzen. Die Komponenten Q9, D2, D4, R3, R4, C3 und C4 arbeiten identisch zu den Komponenten um Q10, nur sind sie für die negative Halbwelle von V0 zuständig. Die beiden D- Flipflops FF1, FF2 und das Nand Gate N1 detektieren die beiden positiven Flanken der Ausgangssignale der Spannungs- Nullpunktdetektoren Q9 und Q10. Dazu schaltet abwechselnd ein Flipflop (FF1 bzw. FF2) am Ausgang Q auf hoch, sobald es am Clock CK getriggert wird. Dieser Zustand wird nach der Laufzeit von N1 sofort wieder über den entsprechenden Reset Eingang zurückgesetzt. So entstehen am Ausgang von N1 Spannungspulse bei jedem Nulldurchgang von V0 (Signalkurve B), welche den Transistor Q2 kurz voll durchsteuern. Diese symmetrische Implementation garantiert identisches Verhalten bezüglich der beiden Spannungshalbwellen von V0. Zudem ist Q2 nur während dem Triggermoment der kurzen Spannungspulse mit V0 gekoppelt. Q7, Q8, R6 und R5 spiegeln einen Steuerstrom, definiert durch die Steuergrösse Control, welcher in den Kondensator C5 fliesst. Es ergibt sich eine Sägezahnspannung über C5 (Kurve C), die zeitlich mit den Aussteuerpulsen von Q2 ihren tiefsten Wert erreicht. Diese Sägezahnspannung triggert FF5 über den Eingang CK sobald dessen Schaltschwelle erreicht ist. Dieser Zeitpunkt ist über den Steuereingang Control steuerbar, weil sich die Steilheit der Sägezahnspannung durch den Kollektorstrom in Q8 und folglich mit Control ändern lässt. FF5, FF6, N3 und N4 bilden den ersten Teil vom Demux. FF5 wird über die Pulse am Set (S) bzw. Reset (R) Eingang so konfiguriert, dass der Sägezahn immer den entsprechenden Schalter ansteuert, welcher für die entsprechende Halbwelle zuständig ist. Dies entspricht der Schaltsignalselektion mittels Signalkurve A. Erscheint V0 mit der positiven Halbwelle, ist D2 leitend. Der Kollektor von Q9 ist hoch und triggert FF2 über CK. Der kurzzeitig gesetzte Ausgang Q von FF2 setzt den Ausgang Q von FF5 über dessen Set (S) Eingang. Das Tief am Ausgang IQ von FF5 erzwingt am Ausgang von N4 ein hoch, welches Q1a über die Treiber Q3, Q4 schliesst. Dies ist die Anfangsbedingung für das gesteuerte Abkoppeln von CM1 und CM2 während der positiven Halbwelle von V0. Wird die Schaltschwelle im PWM Modulator erreicht (die Spannung über C5 ist gleich der Schaltschwelle von FF5), kippt FF5: Q ist tief und IQ hoch. IQ von FF6 ist ebenfalls auf hoch, dadurch schaltet der Ausgang von N4 auf tief, folglich öffnet der Kopplungsschalter Q1a über die Treiber Q3, Q4. Bei der negativen Halbwelle von V0 geschieht ähnliches. FF5 wird über den R Eingang von FF1 zurückgesetzt sobald D1 leitend ist und FF1 über den Clock CK triggert wird. Dies erzwingt am Ausgang von N3 ein hoch, welches Q1b über die Treiber Q5, Q6 schliesst. Dies ist die Anfangsbedingung für das gesteuerte Abkoppeln von CM1 und CM2 während der negativen Halbwelle von V0. Wird die Schaltschwelle im PWM Modulator erreicht (die Spannung über C5 ist gleich der Schaltschwelle von FF5), kippt FF5: Q ist hoch und IQ tief. Q von FF6 ist ebenfalls auf hoch, dadurch schaltet der Ausgang von N3 auf tief, folglich öffnet der Kopplungsschalter Q1b über die Treiber Q5, Q6. Das Schliessen der Schalter wird von Demux2 gesteuert. Hierzu werden die Zustände der beiden Kopplungsschalter Q1a und Q1b über Spannungsmesser detektiert. Die Kondensatoren C5 und C6 greifen die positive Spannungshalbwelle von VQ1 ab. Sie erfassen damit den Zustand von Q1a und steuern über R9 die Basis von Transistor Q11. Q11 agiert als quasi Spannungs- Nullpunktdetektor. D5 und D7 beschleunigen das Abschalten sobald die Spannung über C6 unter die Schwellenspannung von Q11 fällt. Der kapazitive Spannungsteiler C5, C6 verhindert eine Gleichspannungskopplung mit V0. Zudem macht diese integrierende Spannungsmessung den Detektor unempfindlich gegenüber Stromtransienten in der Strommasche um Q1a. Die Komponenten Q12, D6, D8, R10, R12, C7 und C8 arbeiten identisch zu den Komponenten um Q11. Sie sind für die negative Halbwelle von VQ1 zuständig und erfassen damit den Zustand von Q1b. Die beiden D- Flipflops FF3, FF4 und das Nand Gate N2 detektieren die beiden positiven Flankenwechsel der Spannungs- Nullpunktdetektoren Q11 und Q12. Dazu schaltet je ein Flipflop durch, sobald es am Clock CK getriggert wird. Dieser Zustand wird nach der Laufzeit von N2 sofort wieder über den entsprechenden Reset Eingang zurückgesetzt. Dies ergibt am Ausgang von N1 Spannungspulse sobald die Spannung über Q1a bzw. Q1b null wird. Dies signalisiert den Moment an dem der entsprechende Schalter wieder schliessen soll damit er die integrierte Diode überbrücken kann. Dieser "Einschaltbefehl" triggert FF6 am Clock Eingang. Dadurch übernehmen die beiden Ausgänge von FF6 die Zustände von FF5. Dadurch geht N3 bzw. N4 welches vorher am Ausgang tief war auf hoch. Dadurch bleiben ab diesem Zeitpunkt immer beide Schalter Q1a und Q1b bis zum Ende der entsprechenden Halbwelle von V0 geschlossen. Der Vorteil dieser Differenzierung (Flankendetektierung mittels Flipflops) ist die Robustheit gegenüber Transienten, welche erst ab einem Vorzeichenwechsel der Gesamtspannung die Funktion störend beeinträchtigen.

Dies macht den "Einschaltbefehl" der Schalter Q1a und Q1b unempfindlich gegenüber Transienten im Netzwerk.
Das Flipflop FF6 synchronisiert sich selbst nach spätestens einer Schwingkreisperiode nach dem Einschalten der gesamten Schaltung. Dann hat immer mindestens einer der Kopplungsschalter Q1a bzw. Q1b einmal geöffnet und einen Clockpuls für FF6 generiert.

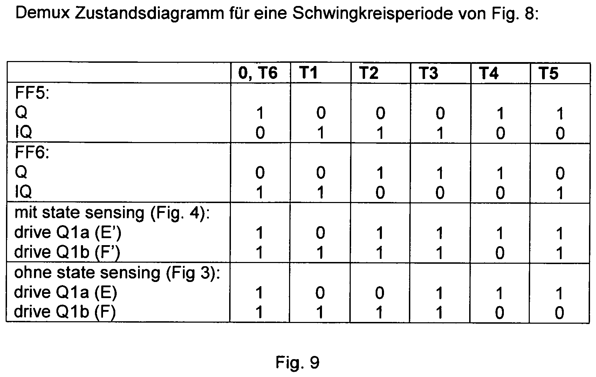

Figur 9 zeigt eine Zusammenfassung der Demux Signalzustände über eine Schwingkreisperiode jeweils nach Clock (CK) Triggerung der entsprechenden Flipflops. Die Ausgangssignale des Zustandsdiagramms entsprechen den Signalen E, E' bzw. F und F' der Figur 5.
Eine wesentliche Vereinfachung der Schaltung ergibt sich nach dem Ansatz der Figur 3. Dort entfallen die Blöcke State- Sense und Demux2. Somit führt man den Ausgang vom Nand N1 direkt an den Clock Eingang (CK) von FF6. Die Ausgangssignale von FF5 und Demux sind ebenfalls in Figur 9 dargestellt.
Die einfachste Ansteuerschaltung erhält man, wenn die Schalter über die einfache Frequenzteilung mittels FF5 angesteuert werden. In diesem Fall fallen FF6, N3 und N4 sowie die Blöcke State- Sense und Demux2 weg. Der Ausgang Q von FF5 wird direkt mit dem Eingang von Treiber Q3 und Q4 verbunden. Der Ausgang IQ von FF5 wird direkt mit dem Eingang von Treiber Q5 und Q6 verbunden. Diese Variante weist aber den schlechtesten Wirkungsgrad auf.

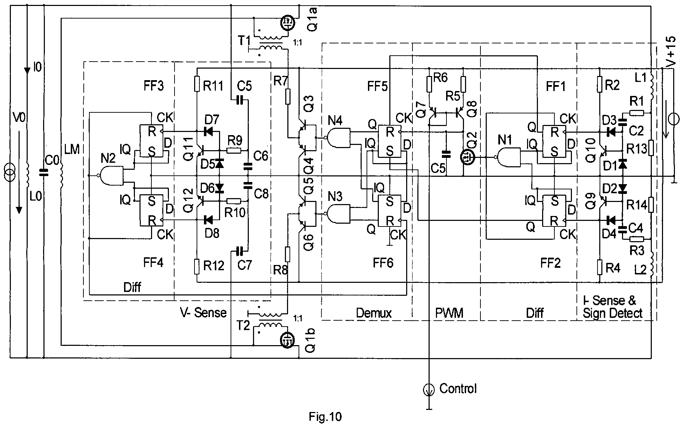

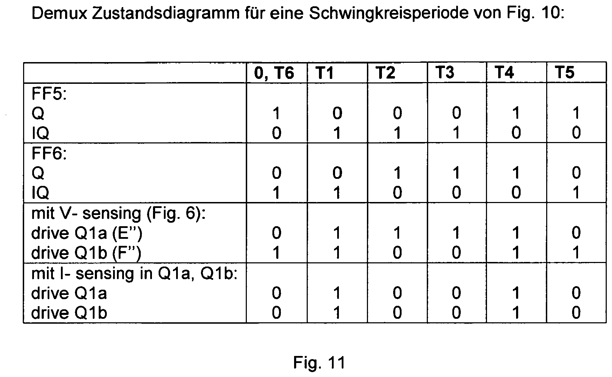

Figur 10 zeigt eine Detailschaltung nach Figur 6. Die gestrichelten Linien umfassen Teile des Blockschaltbildes. In der weiteren Beschreibung werden Kurvenformen der Figur 7 mit deren Indizes referenziert. LM wird über Q1a und Q1b an L0 gekoppelt. Die Schalteransteuerung wird an einer Spannung V+15 mit beliebigen Referenzpotential betrieben. Die erforderlichen Steuersignale der Kopplungsschalter Q1a und Q1b werden galvanisch getrennt über die Transformatoren T1 bzw. T2 an Q1a bzw. Q1b gekoppelt. Alternativ kann ein Optokoppler mit nachfolgendem Treiber benützt werden (nicht gezeigt). Bei der Benützung eines Optokopplers anstelle von T1 bzw. T2 können die Treiberstufen Q3...Q6 entfallen. Der Vorteil einer einzigen Induktivität LM sind der grössere Wirkungsgrad und tiefere Kosten. Weiter wird der Steuerstrom (Control) nun ohne galvanische Trennung zugeführt. Die Induktivität L1 greift die positive Stromhalbwelle von I0 ab und führt sie mittels Shuntwiderstand R13 über R1 und C2 an die Basis von Transistor Q10. Q10 agiert als quasi Strom-Nullpunktdetektor der positiven Halbwelle. D1 und D3 beschleunigen das Abschalten sobald der Strom durch C2 sein Vorzeichen wechselt. Weiter verhindert C2 eine Gleichstromkopplung mit I0. Zusätzlich lässt sich über L1, R1, R13 und C2 eine Phasenvordrehung erreichen. Zu diesem Zweck sind diese Komponenten so dimensioniert, dass die Phasenvordrehung mindestens so gross ist wie die gesamte Signalverzögerung der Steuerschaltung. Dadurch lässt sich der komplette Aussteuerbereich nutzen. Die Komponenten Q9, D2, D4, R3, R4, R14, C4 und L2 arbeiten identisch zu den Komponenten um Q10, nur sind sie für die negative Stromhalbwelle von I0 zuständig. Die beiden D- Flipflops FF1, FF2 und das Nand Gate N1 detektieren die beiden positiven Flanken der Ausgangssignale der Strom- Nullpunktdetektoren Q9 und Q10. Dazu schaltet abwechselnd ein Flipflop (FF1 bzw. FF2) am Ausgang Q auf hoch, sobald es am Clock CK getriggert wird. Dieser Zustand wird nach der Laufzeit von N1 sofort wieder über den entsprechenden Reset Eingang zurückgesetzt. So entstehen am Ausgang von N1 Spannungspulse bei jedem Nulldurchgang von I0 (Signalkurve B), welche den Transistor Q2 kurz voll durchsteuern. Diese symmetrische Implementation garantiert identisches Verhalten bezüglich der beiden Stromhalbwellen von I0. Zudem ist Q2 nur während dem Triggermoment der kurzen Spannungspulse mit I0 gekoppelt. Q7, Q8, R6 und R5 spiegeln einen Steuerstrom, definiert durch die Steuergrösse Control, welcher in den Kondensator C5 fliesst. Es entsteht eine Sägezahnspannung über C5 (Kurve C), die zeitlich mit den Aussteuerpulsen von Q2 ihren tiefsten Wert erreicht. Diese Sägezahnspannung triggert FF5 über den Eingang CK sobald dessen Schaltschwelle erreicht ist. Dieser Zeitpunkt ist über den Steuereingang Control steuerbar, weil sich die Steilheit der Sägezahnspannung durch den Kollektorstrom in Q8 und folglich mit Control ändern lässt. FF5, FF6, N3 und N4 bilden den ersten Teil vom Demux. FF5 wird über die Pulse am Set (S) bzw. Reset (R) Eingang so konfiguriert, dass der Sägezahn immer den entsprechenden Schalter ansteuert, welcher für die entsprechende Halbwelle zuständig ist. Dies entspricht der Schaltsignalselektion mittels Signalkurve A. Erscheint I0 mit der positiven Halbwelle, ist D2 leitend. Der Kollektor von Q9 ist hoch und triggert FF2 über CK. Der kurzzeitig gesetzte Ausgang Q von FF2 setzt den Ausgang Q von FF5 über dessen Set (S) Eingang. Das Hoch am Ausgang Q von FF5 erzwingt am Ausgang von N4 ein Tief, welches Q1a über die Treiber Q3, Q4 öffnet. Dies ist die Anfangsbedingung für das gesteuerte Ankoppeln von LM während der positiven Halbwelle von I0. Wird die Schaltschwelle im PWM Modulator erreicht (die Spannung über C5 ist gleich der Schaltschwelle von FF5), kippt FF5 und dessen Ausgang Q wird tief. Da IQ von FF6 unverändert hoch ist, schaltet der Ausgang von N4 auf hoch, folglich schliesst der Kopplungsschalter Q1a über die Treiber Q3, Q4. Bei der negativen Halbwelle von I0 geschieht ähnliches. Der invertierte Ausgang IQ von FF5 wird über den Reset (R) Eingang von FF1 gesetzt sobald D1 leitend ist und FF1 über den Clock (CK) triggert wird. Dies erzwingt am Ausgang von N3 ein tief, welches Q1b über die Treiber Q3, Q4 öffnet. Dies ist die Anfangsbedingung für das gesteuerte Ankoppeln von LM während der negativen Halbwelle von I0. Wird die Schaltschwelle im PWM Modulator erreicht (die Spannung über C5 ist gleich der Schaltschwelle von FF5) kippt FF5 und dessen invertierter Ausgang IQ wird tief. Da Q von FF6 unverändert hoch ist, schaltet der Ausgang von N3 auf hoch, folglich schliesst der Kopplungsschalter Q1b über die Treiber Q5, Q6. Das Öffnen der Schalter wird von Demux2 gesteuert. Hierzu wird der Nulldurchgang der Spannung V0 detektiert mit einem Spannungs- Nullpunktdetektor von Figur 8. Die Blöcke V-Sense und Diff mit all ihren Komponenten sind identisch in den Figuren 8 und 11 und sind deshalb nicht mehr näher erläutert. Die Pulse K am Ausgang von N2 signalisieren den Moment an dem der entsprechende Schalter wieder öffnen soll. Dieser "Ausschaltbefehl" triggert FF6 am Clock Eingang. Dadurch übernehmen die beiden Ausgänge von FF6 die Zustände von FF5. Für die positive Stromhalbwelle von I0 bleibt N3 auf hoch, N4 hingegen geht auf tief. Für die negative Stromhalbwelle von I0 bleibt N4 auf hoch, N3 hingegen geht auf tief. Dadurch bleibt ab diesem Zeitpunkt (V0 Zerocrossing) immer nur noch einer der Schalter Q1a und Q1b der entsprechenden Halbwelle von I0 geschlossen. Dadurch wird das Abkoppeln von LM nur von den integrierten Dioden in Q1a bzw. Q1b bestimmt. Eine Phasenvoreilung im Block V- Sense ist nicht mehr unbedingt notwendig. Eine entsprechende Signallaufzeitverzögerung hält die Schalter länger geschlossen was die Verluste weiter reduziert. Die wichtige Grenzbedingung, dass der Schalter Q1a bzw. Q1b spätestens mit der internen Diode öffnen muss bleibt aber unbedingt einzuhalten.
Der Vorteil dieser Differenzierung (Flankendetektierung mittels Flipflops) ist die Robustheit gegenüber Transienten, welche erst ab einem Vorzeichenwechsel der Gesamtspannung (V0) die Funktion störend beeinträchtigen. Dies macht den "Ausschaltbefehl" der Schalter Q1a und Q1b unempfindlich gegenüber Transienten des Resonanzkreises. Das Flipflop FF6 synchronisiert sich selbst nach spätestens einer Schwingkreisperiode nach dem Einschalten der gesamten Schaltung. Dann hat immer mindestens einer der Kopplungsschalter Q1a bzw. Q1b einmal geöffnet und einen Clockpuls für FF6 generiert.

Figur 11 zeigt eine Zusammenfassung der Demux Signalzustände über eine Schwingkreisperiode jeweils nach clock (CK) Triggerung der entsprechenden Flipflops. Die Ausgangssignale des Zustandsdiagramms entsprechen den Signalen E" bzw. F" der Figur 6.
Eine weitere mögliche Ansteuervariante wäre, den Strom in den Kopplungsschaltern Q1a und Q1b abzugreifen (nicht gezeigt in Figur 10). Die Kopplungsschalterfläche wird in einen kleinen Sense Pfad aufgeteilt. Dadurch entsteht ein identischer Sense- MOSFET. Der Ausgang dieses Sense-MOSFETs wird auf einen Komparator geführt, der den Kopplungsschalter Stromnullpunkt detektiert und nachfolgend den Diff- Block Eingang speist. Alternativ zum Sense MOSFET kann auch die Spannung über Rdson mit einem Komparator gemessen werden. Eine dieser beiden Möglichkeiten wird vor allem in einer integrierten Schaltersteuerung empfohlen. Solche Strom-Senseimplementationen sind bereits verbreitet in Ausgangsstufen von z. Bsp. integrierten Schaltnetzteilen.
Das Demux Zustandsdiagramm dieser Variante ist auch in Figur 11 gezeigt. Optimaler Weise können beide Schalter identisch angesteuert werden. I0 Nulldurchgang (Signalkurve B in Figur 6) definiert das Öffnen beider Kopplungschalter. Das PWM (die Spannung über Kondensator C5) steuert das Schliessen beider Kopplungsschalter, und der Stromnullpunkt im Kopplungsschalter steuert das Öffnen beider Kopplungsschalter.
Die einfachste Ansteuerschaltung erhält man, wenn die Schalter über die einfache Frequenzteilung mittels FF5 angesteuert werden. In diesem Fall fallen FF6, N3 und N4 sowie die beiden linken Blöcke V-Sense und Diff weg. Der Ausgang IQ von FF5 wird direkt mit dem Eingang von Treiber Q3 und Q4 verbunden. Der Ausgang Q von FF5 wird direkt mit dem Eingang von Treiber Q5 und Q6 verbunden. Diese Variante weist aber den schlechtesten Wirkungsgrad auf.

## Patentansprüche

1. Ein elektrisches Resonanznetzwerk dessen Resonanzfrequenz,
Scheinwiderstand oder Scheinleitwert elektrisch gesteuert wird umfassend:
a) mindestens eine erste Induktivität (L0) und mindestens eine erste Kapazität (C0) die miteinander einen Schwingkreis bilden,
b) mindestens eine Reaktanz (CM, LM),
c) mindestens einen Schalter, gesteuert von mindestens einem ON/OFF Signal (E, E', E", F, F', F"), um die mindestens eine Reaktanz (CM, LM) an den Schwingkreis zu koppeln, wobei der Lade- und Entladevorgang der mindestens einen Reaktanz (CM, LM) durch den Schwingkreis erfolgt und das mindestens eine ON/OFF Signal (E, E', E", F, F', F") mindestens einmal innerhalb der Schwingkreisperiode wechselt,
d) eine Schaltersteuerung, die das mindestens eine ON/OFF Signal (E, E', E", F, F', F") basierend auf einer Pulsweitenmodulation (PWM) generiert und **dadurch gekennzeichnet ist,**
**dass** mindestens ein quasi Nullpunktdetektor (V-Sense, I-Sense, Q9, Q10, Q11, Q12) die positiven und negativen Spannungs- oder Stromhalbwellen des Schwingkreises mittels einem Schwellenwert detektiert um das mindestens eine ON/OFF Signal (E, E', E", F, F', F") zu generieren.

2. Ein elektrisches Resonanznetzwerk nach Anspruch 1 **dadurch gekennzeichnet, dass** die mindestens eine Reaktanz (CM, LM) mindestens eine zweite Kapazität (CM) ist und der mindestens eine quasi
Nullpunktdetektor als quasi Spannungs-Nullpunktdetektor agiert.

3. Ein elektrisches Resonanznetzwerk nach Anspruch 1 **dadurch gekennzeichnet, dass** die mindestens eine Reaktanz (CM, LM) mittels mindestens zweier Schalter (Q1a, Q1b) an den Schwingkreis gekoppelt wird und jeder dieser Schalter (Q1a, Q1b) die Kopplung der mindestens einen Reaktanz (CM, LM) mit dem Schwingkreis an unterschiedlichen Strom- oder Spannungshalbwellen der Schwingkreisperiode steuert.

4. Ein elektrisches Resonanznetzwerk nach Anspruch 1 **dadurch gekennzeichnet, dass** die mindestens eine Reaktanz (CM, LM) mindestens eine zweite Induktivität (LM) ist und der mindestens eine quasi Nullpunktdetektor als quasi Strom-Nullpunktdetektor agiert.

5. Ein elektrisches Resonanznetzwerk nach einem der Ansprüche 1 bis 4 **dadurch gekennzeichnet, dass** mindestens ein ON/OFF Signal (E, E', E", F, F', F") so den Schaltern zugeführt wird, dass mindestens eine funktionelle Diodenstrecke mindestens teilweise mit einem ON Signal (E, E', E", F, F', F") zeitlich zusammenfällt, um deren Stromfluss mindestens teilweise zu entlasten.

6. Ein elektrisches Resonanznetzwerk nach Anspruch 1 **dadurch gekennzeichnet, dass** die Pulslänge des mindestens einen ON/OFF Signals (E, E', E", F, F', F") von einer Steuergröße (Control) gesteuert wird.

7. Ein elektrisches Resonanznetzwerk nach Anspruch 1 **dadurch gekennzeichnet, dass** das mindestens eine ON/OFF Signal (E, E', E", F, F', F") basierend einer Pulsweitenmodulation (PWM) generiert wird und der mindestens eine quasi Nullpunktdetektor (V-Sense, I-Sense, Q9, Q10, Q11, Q12) die Pulsweitenmodulation (PWM) synchronisiert.

## Claims

1. An electrical resonant network whose resonance frequency, impedance or admittance is electrically controlled comprising:
a) at least one first inductance (L0) and at least one first capacitance (C0) which form together a resonant circuit,
b) at least one reactance (CM, LM),
c) at least one switch, controlled by at least one ON / OFF signal (E, E', E", F, F', F") for coupling the at least one reactance (CM, LM) to the resonant circuit, wherein the at least one reactance (CM, LM) is charged and discharged by the resonant circuit and the at least one ON / OFF signal (E, E', E", F, F', F") altering at least once within the resonant circuit period,
d) a switch control circuit, which generates the at least one ON / OFF signal (E, E', E", F, F', F") based on a pulse width modulation (PWM) and is **characterized**
**in that** at least one quasi-zero detector (V-sense, I-sense, Q9, Q10, Q11, Q12) detecting the positive and negative voltage- or current half-waves of the resonant circuit by means of a threshold level for generating the at least one ON / OFF signal (E, E', E", F, F', F").

2. An electrical resonant network according to claim 1, **characterized in that** the at least one reactance (CM, LM) is at least one second capacitance (CM) and the at least one quasi-zero detector acts as a quasi-zero voltage detector.

3. An electrical resonant network according to claim 1, **characterized in that** the at least one reactance (CM, LM) is coupled by at least two switches (Q1a, Q1b) to the resonant circuit and each of these switches (Q1a, Q1b) control the coupling of the at least one reactance (CM, LM) with the resonant circuit at different current- or voltage half waves of the resonant circuit period.

4. An electrical resonant network according to claim 1, **characterized in that** the at least one reactance (CM, LM) is at least one second inductance (LM) and the at least one quasi-zero detector acts as a quasi-zero current detector.

5. An electrical resonant network according to any one of the claims 1 to 4, **characterized in that** at least one ON / OFF signal (E, E', E", F, F', F") controls the switches such that at least one functional diode path coincides temporarily at least partially with an ON signal (E, E', E", F, F', F") to relieve the current flow in the diode at least partially.

6. An electrical resonant network according to claim 1, **characterized in that** the pulse length of the at least one ON / OFF signal (E, E', E", F, F', F") is controlled by a control variable (Control).

7. An electrical resonant network according to claim 1, **characterized in that** the at least one ON / OFF signal (E, E', E", F, F', F") is generated based on a pulse width modulation (PWM) and the at least one quasi-zero detector (V-sense, I-sense, Q9, Q10, Q11, Q12) synchronizes the pulse width modulation (PWM).

## Revendications

1. Circuit électrique résonnant dont la fréquence de résonance, l'impédance ou l'admittance est contrôlée électriquement, comprenant:
a) au moins une première inductance (L0) et au moins une première capacité (C0) qui forment ensemble un circuit résonant,
b) au moins une réactance (CM, LM),
c) au moins un interrupteur commandé par au moins un signal ON / OFF (E, E', E", F, F', F") pour coupler ladite au moins une réactance (CM, LM) au circuit résonnant, dans lequel la charge et la décharge de la dite au moins une réactance (CM, LM) est effectuée par le circuit oscillant et le au moins un signal ON / OFF (E, E', E", F, F', F") commute au moins une fois pendant la de période du circuit résonnant,
d) un dispositif de commande de commutateur, qui génère au moins un signal ON / OFF (E, E', E", F, F', F") sur la base d'une modulation de largeur d'impulsion PWM) et **caractérisé en ce**
**qu'**au moins un détecteur de point quasi-nul (V-Sense, I-Sense, Q9, Q10, Q11, Q12), détecte les demi-ondes positive et négative de tension et de courant du circuit de résonance est détectée au moyen d'une valeur de seuil pour générer le au moins un signal ON / OFF (E, E', E", F, F', F").

2. Un réseau électrique résonnant selon la revendication 1, **caractérisé en ce que** l'au moins une réactance (CM, LM) est au moins une deuxième capacité (CM) et le au moins un détecteur de point quasi-nulle agit en tant que détecteur de point quasi-tension nulle.

3. Un réseau électrique résonnant selon la revendication 1, **caractérisé en ce que** l'au moins une réactance (CM, LM) est couplée par au moins deux commutateur (Q1a, Q1b) au circuit résonnant et chacun de ces commutateurs (Q1a, Q1b) commande le couplage d'au moins une réactance (CM, LM) avec le circuit résonnant à différents demi-cycles de courant ou de tension des commandes de la période de résonnance du circuit résonant.

4. Un réseau électrique résonnant selon la revendication 1, **caractérisé en ce que** l'au moins une réactance (CM, LM) est au moins une seconde inductance (LM) et le au moins un détecteur de point quasi-nulle agit en tant que détecteur de courant quasi point zéro.

5. Un réseau électrique de résonance selon l'une quelconque des revendications 1 à 4, **caractérisée en ce qu'**au moins un signal ON / OFF (E, E', E", F, F', F") est alors fourni aux commutateurs et qu'au moins une courbe de fonction de la diode coïncide temporellement au moins partiellement avec un signal ON (E, E', E", F, F', F") pour décharger leur courant au moins partiellement.

6. Un réseau électrique résonnant selon la revendication 1, **caractérisé en ce que** la longueur d'impulsion de l'au moins un signal ON / OFF (E, E', E", F, F', F") est commandé par une variable de contrôle (control).

7. Un réseau électrique résonnant selon la revendication 1, **caractérisé en ce que** le au moins un signal ON / OFF (E, E', E", F, F', F") est généré en fonction d'une modulation de largeur d'impulsion (PWM) et le au moins un détecteur de point quasi-nul (V-sense, I-sense, Q9, Q10, Q11, Q12) synchronise la modulation de largeur d'impulsion (PWM).
